# FASCICULE DE BREVET EUROPEEN

(11) **EP 2 726 888 B1**
(45) Date de publication et mention de la délivrance du brevet: **15.06.2022**
(21) Numéro de dépôt: 12728596.3
(22) Date de dépôt: 21.06.2012
(51) Int. Cl.: G01R 31/12

(54) **PROCEDE ET DISPOSITIF DE CONTROLE D'UN POSTE ELECTRIQUE HAUTE TENSION ISOLE AU GAZ**
VERFAHREN UND VORRICHTUNG ZUR STEUERUNG EINER GASISOLIERTEN ELEKTRISCHEN HOCHSPANNUNGSSCHALTANLAGE
METHOD AND DEVICE FOR CONTROLLING A GAS-INSULATED HIGH-VOLTAGE ELECTRICAL SUBSTATION

(30) Priorité: 30.06.2011 FR 1155902
(43) Date de publication de la demande: 07.05.2014
(73) Titulaire: General Electric Technology GmbH, 5400 Baden (CH)
(72) Inventeur: PENNING, Jean-François, F-73410 La Biolle (FR); CUSSAC, Grégory, F-38690 Oyeu (FR); GARCIA, Antoine, 34590 MARSILLARGUES (FR)
(74) Mandataire: Brevalex
(86) Numéro de dépôt international: PCT/EP2012/061931
(87) Numéro de publication internationale: WO 2013/000806

(56) Documents cités:
- EP-A1- 1 484 616
- WO-A1-2010/111334
- WO-A1-2010/130671
- WO-A2-2010/008168
- JP-A- 2001 249 156
- JP-A- 2011 085 393
- US-A1- 2008 103 712
- US-A1- 2010 079 148
- US-A1- 2010 324 746
- FRUTH B A ET AL: "Combination of frequency spectrum analysis and partial discharge pattern recording", CONFERENCE RECORD OF THE IEEE INTER NATIONAL SYMPOSIUM ON ELECTRICAL INSULATION, 1994, PITTSBURGH, PA, USA, 5 juin 1994 (1994-06-05), - 8 juin 1994 (1994-06-08), pages 296-300, XP010139506, IEEE NEW YORK, NY, USA DOI: 10.1109/ELINSL.1994.401508 ISBN: 978-0-7803-1942-4
- DATABASE WPI Week 200234 Thomson Scientific, London, GB; AN 2002-301756 XP002671016, -& KR 2001 0079445 A (LG CABLE CO LTD) 22 août 2001 (2001-08-22)
- CHUL-MIN HWANG ET AL: "UHF Partial Discharge fixed and portable monitoring systems for prevent of the failure in Gas-Insulated Switchgear(GIS)", CONFERENCE RECORD OF THE IEEE INTERNATIONAL SYMPOSIUM ON ELECTRICAL INSULATION, ISEI 2008., 9 juin 2008 (2008-06-09), pages 400-403, XP031464718, EEE, PISCATAWAY, NJ, USA ISBN: 978-1-4244-2091-9

## Description

### DOMAINE TECHNIQUE

L'invention se rapporte au domaine des postes électriques à haute tension isolés au gaz et des procédés de contrôle de ces mêmes postes.

L'avènement des postes électriques à haute tension isolés au gaz à permis une réduction drastique du volume occupé par les postes électriques en ville. En effet, le gaz utilisé pour l'isolation, tel que l'hexafluorure de soufre (SF₆), est un gaz présentant une forte rigidité diélectrique. Celui-ci permet, par son emploi en combinaison avec une haute pression, de réduire la distance d'isolement nécessaire entre les phases dans le poste électrique et donc du volume occupé par ce même poste électrique.

Avec la généralisation de ces postes électriques à hautes tension, il a été nécessaire de développer des procédés de contrôle adaptés.

L'invention concerne plus particulièrement, un procédé de contrôle d'un poste électrique haute tension isolé au gaz, un dispositif de contrôle utilisé pour effectuer ce procédé et un procédé mis en œuvre par un ordinateur permettant de mettre en œuvre ledit procédé avec le dispositif de contrôle.

### ÉTAT DE LA TECHNIQUE ANTÉRIEURE

Un des procédés généralement employés pour détecter des défauts d'un poste électrique à haute tension isolé au gaz est le procédé de détection des décharges partielles par la méthode Ultra Haute Fréquence (d'acronyme UHF).

Un tel procédé utilise la détection des signatures électromagnétiques dans les UHF des décharges partielles qui ont lieu dans un poste électrique présentant un défaut.

Le procédé généralement employé consiste à mesurer, à partir d'un capteur UHF interne du poste électrique à contrôler, les ondes électromagnétiques sur une large bande de fréquence UHF comprise généralement entre 300 et 1200 MHz pendant le fonctionnement du poste électrique. Ainsi, si des ondes électromagnétiques UHF sont détectées dans cette bande de fréquence UHF, il en est déduit que le poste électrique doit être révisé.

Néanmoins, si un tel procédé permet bien de détecter un défaut dans un poste électrique, la perméabilité de l'enveloppe d'un poste électrique peut entraîner des erreurs de détection. En effet, en environnement urbain les pollutions électromagnétiques dans les UHF ne sont pas rares, celles-ci ayant généralement pour origine les émissions télévisuelles ou les réseaux de télécommunication. De telles pollutions peuvent présenter des signatures électromagnétiques similaires aux ondes électromagnétiques issues d'une décharge partielle et engendrer la détection erronée d'un défaut générant des coûts de maintenance non nécessaire du poste électrique.

Pour réduire les effets de ces pollutions électromagnétiques, il est connu d'utiliser, en complément au capteur UHF interne, un capteur UHF externe au poste électrique, et ainsi en déduire le bruit lié à l'environnement extérieur. Selon cette possibilité, le bruit mesuré par le capteur externe est soustrait du signal mesuré par le capteur interne pour conserver principalement les signaux issus des décharges partielles.

Néanmoins, si une telle possibilité permet une suppression partielle du bruit lié aux pollutions électromagnétiques, elle pâtie de la transparence de l'enveloppe du poste électrique. En effet, le capteur externe n'est pas sensible qu'aux pollutions électromagnétiques extérieures au poste électrique mais également aux ondes électromagnétiques émises lors d'une décharge partielle. Il en résulte donc, qu'en raison de la transparence partielle de l'enveloppe, la soustraction des signaux mesurés par le capteur externe aux signaux mesurés par le capteur interne, est à l'origine d'une atténuation des signaux mesurés en combinaison avec une suppression du bruit lié aux pollutions électromagnétiques qui reste que partielle. La signature d'une décharge partielle peut s'en retrouver amoindrie et difficilement detectable. Un tel état de la technique antérieur est divulgué dans le document EP 1 484 616 A1.

### EXPOSÉ DE L'INVENTION

Un des but de l'invention est de fournir un procédé de contrôle d'un poste électrique haute tension isolé au gaz avec une sensibilité améliorée pour la détection de la signature électromagnétique d'une décharge partielle quelque soit les pollutions électromagnétiques extérieures au poste électrique.

A cette effet, l'invention se rapporte à un procédé de contrôle d'un poste électrique haute tension isolé au gaz, ledit poste électrique comportant au moins un capteur interne adapté pour mesurer des ondes électromagnétiques Ultra Haute Fréquence (UHF), le procédé comportant les étapes consistant à :
a) acquérir parallèlement au moins un premier spectre en fréquence des signaux reçus par l'au moins un capteur interne et au moins un deuxième spectre en fréquence des signaux reçus par au moins un capteur externe au poste électrique, l'au moins un premier spectre et l'au moins un deuxième spectre étant acquis sur une plage de fréquence UHF,
b) calculer un spectre en fréquence du rapport signal sur bruit à partir du au moins un premier spectre et l'au moins un deuxième spectre, l'au moins un premier spectre correspondant au signal et l'au moins un deuxième spectre correspondant au bruit,
c) déterminer dans la plage de fréquence la présence d'au moins un maximum du rapport signal sur bruit, signature de la présence d'au moins une décharge partielle.

Un tel procédé en réalisant à la fois un spectre en fréquence du signal UHF issu du poste électrique à contrôler et un spectre fréquence du bruit et en déterminant par un calcul d'un spectre du rapport signal sur bruit permet de détecter une bande de fréquence pour laquelle le signal d'une décharge partielle est présent sans être significativement impacté par les pollutions électromagnétiques extérieures. Un tel procédé permet donc une détection fiable de la signature d'une décharge électromagnétique quelles que soient les pollutions électromagnétiques extérieures.

Le procédé peut comprendre en outre après l'étape c), les étapes consistant à :
d) sélectionner une fréquence d'acquisition correspondant à l'un des maximums de signal sur bruit détectés lors de l'étape c),
e) acquérir à partir de l'au moins un capteur interne la variation temporelle des signaux dans une bande de fréquence centrée autour de la fréquence d'acquisition,
f) comparer ladite variation temporelle avec une variation temporelle d'une tension de synchronisation du poste électrique.

Ce procédé en offrant la possibilité de comparer la variation temporelle des signaux UHF signature d'une décharge partielle et la variation temporelle d'une tension de synchronisation du poste électrique permet une identification du type de défaut à l'origine de la décharge partielle.

La plage de fréquence peut présenter des bornes inférieure et supérieure comprises entre 200 MHz et 3 GHz et préférentiellement comprises entre 300 MHz et 1200 MHz.

De telles bandes de fréquence permettent une bonne détection des signatures électrostatique des décharges partielles susceptibles d'exister dans un poste électrique.

La bande de fréquence peut posséder une largeur de bande inférieure ou égale à 10 MHz et préférentiellement inférieure ou égale à 3 MHz.

Une telle largeur de bande permet de réduire les risques de présence d'un bruit lié aux pollutions électromagnétiques extérieures sur une bande de fréquence à laquelle on détecte une signature électromagnétique d'une décharge partielle.

La tension de synchronisation peut être une tension dont la source est choisie dans le groupe comportant un transformateur inductif du poste électrique, un capteur capacitif du poste électrique et une alimentation basse tension d'une sous-station du poste électrique.

Une telle tension de synchronisation permet de synchroniser les mesures par rapport aux tensions du poste électrique et à leurs phases de manière à permettre la détermination du type du défaut à l'origine des décharges partielles.

L'invention se rapporte également à un dispositif de contrôle d'un poste électrique haute tension isolé au gaz selon la revendication 6.

Un tel dispositif de contrôle permet d'effectuer les mesures nécessaires sur un poste électrique haute tension isolé au gaz pour la détection fiable de la signature électromagnétique d'une décharge partielle.

Le dispositif de contrôle peut comprendre en outre au moins un moyen d'acquisition d'une tension de synchronisation, l'au moins un moyen de traitement étant en outre adapté pour communiquer avec le moyen d'acquisition d'une tension de synchronisation.

Un tel accès à une tension de synchronisation du poste électrique permet, par la possibilité de comparer la variation temporelle d'une signature UHF d'une décharge partielle avec la variation temporelle de ladite tension de synchronisation, une identification du type de défaut à l'origine de cette décharge partielle

Le dispositif de contrôle peut comprendre au moins deux moyens de traitement adaptés chacun pour traiter des signaux de l'un des au moins deux moyens d'acquisition.

Chacun des moyens d'acquisition du dispositif de contrôle comprend un tuner UHF adapté pour acquérir des signaux UHF sur une bande de fréquence variable, le tuner UHF étant en outre adapté pour balayer la bande de fréquence variable sur une plage de fréquence UHF.

Un tel tuner UHF offre la possibilité de balayer la bande de fréquence variable sur une plage de fréquence UHF permettant ainsi, selon les besoins, une acquisition des signaux sur une bande de fréquence constante, telle qu'une bande de fréquence centrée sur une fréquence d'acquisition, et la réalisation d'un spectre en fréquence en balayant la bande de fréquence variable sur la plage de fréquence UHF.

Chaque tuner UHF est un tuner du type hétérodyne.

Un tuner du type hétérodyne permet de fournir un tuner UHF permettant un balayage de la fréquence d'acquisition robuste et de bonne qualité.

Le dispositif de contrôle peut comporter en outre un moyen de connexion informatique adapté pour connecter l'au moins un moyen de traitement avec un ordinateur, le au moins un moyen de traitement étant adapté pour être contrôlé par un ordinateur.

Un tel moyen de connexion informatique permet un traitement des signaux issus du dispositif de contrôle par un ordinateur facilitant ainsi l'enregistrement et la manipulation des signaux issus des capteurs.

L'invention se rapporte également à un Procédé mis en œuvre par un ordinateur selon la revendication 11.

Un tel procédé permet de réaliser une détection d'une décharge partielle dans un poste électrique.

Le procédé peut comprendre en outre après l'étape c') les étapes consistant à :
d') attendre que l'utilisateur sélectionne une fréquence d'acquisition correspondant à un maximum du rapport signal sur bruit,
e') commander l'au moins un moyen de traitement pour faire une acquisition, pendant une durée donnée et dans une bande fréquence centrée autour de la fréquence d'acquisition, par au moins un des aux moins deux moyens d'acquisition de signaux des signaux reçus par au moins un capteur correspondant, le au moins un capteur correspondant à l'au moins un des au moins deux moyens d'acquisition étant au moins un capteur interne du poste électrique, l'au moins un moyen de traitement étant en outre commandé pour faire acquérir, sensiblement simultanément, la variation temporelle de la tension de synchronisation par le moyen d'acquisition de la tension de synchronisation
f') afficher un graphique présentant une variation temporelle comparée entre les signaux acquis par l'au moins un moyen d'acquisition à l'étape e') et la tension de synchronisation acquise à l'étape e').

Un tel procédé permet d'identifier le type du défaut à l'origine des décharges partielles détectées.

Le procédé peut être adapté en outre pour faire une acquisition successive de spectres en fréquence des signaux d'au moins un des capteurs et afficher à l'écran sur demande de l'utilisateur le dernier spectre en fréquence des signaux enregistrés, un spectre moyenné sur les n derniers spectres et un spectre des amplitudes maximales des signaux enregistrés lors des acquisitions successives.

Une telle adaptation permet l'acquisition des spectres en fréquence caractéristiques du poste électrique qui peuvent être analysés pour déterminer si le poste présente un défaut nécessitant une intervention.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre un exemple d'un dispositif de contrôle selon l'invention lors d'un contrôle d'un poste électrique haute tension isolé au gaz,
- la figure 2 illustre le même exemple d'un dispositif de contrôle selon l'invention seul,
- la figure 3 illustre un exemple de schéma fonctionnel d'un dispositif de contrôle selon l'invention,
- les figures 4a à 4c, illustrent respectivement un exemple de spectre en fréquence des signaux issus d'un capteur interne d'un poste électrique, un exemple de spectre en fréquence issus d'un capteur externe, et un spectre du rapport signal sur bruit obtenu à partir des précédents signaux, ces spectres étant tracés sur une échelle en dB et sur une plage de fréquence de 300 à 1200 MHz,
- la figure 5 illustre un exemple de comparaison entre les signaux issus d'un capteur interne d'un poste électrique et la tension de synchronisation du même poste électrique,
- la figure 6 illustre une installation dans un poste électrique comportant plusieurs dispositifs de surveillance installés à demeure dans ledit poste électrique.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

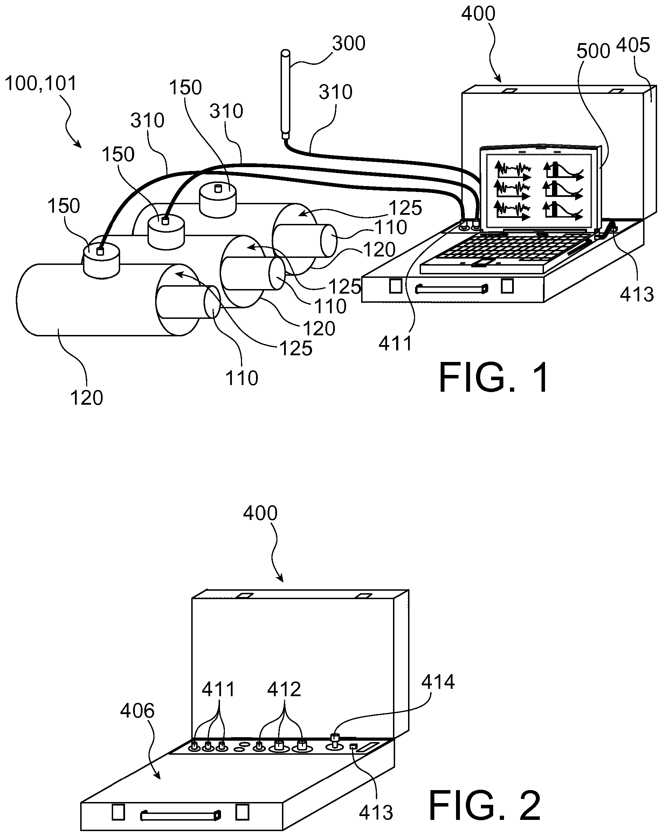

La figure 1 illustre la mise en œuvre d'un procédé de contrôle sur un élément 101 de poste électrique 100 haute tension isolé au gaz avec un dispositif de contrôle 400 mis en œuvre par un ordinateur 500.

L'élément 101 de poste électrique 100 qui est illustré sur la figure 1 comprend :
- trois conducteurs 110 électriques conduisant chacun le courant d'une phase d'une tension triphasée,
- trois enveloppes 120 du poste électrique chacune agencées pour envelopper un des conducteurs 110 et délimitant une enceinte 125 contenant un gaz isolant, tel que de l'hexafluorure de soufre,
- trois capteurs internes 150 installés chacun dans une des enceintes 125 de manière à mesurer des signaux UHF présent dans ladite enceinte 125,
- une tension de synchronisation (non illustrée) donnant un accès à la phase des tensions du poste électrique.

Le procédé comprend en outre la mise en place à l'extérieur du poste électrique 100, d'un capteur externe 300 pour permettre la mesure des pollutions électromagnétiques présentes à l'extérieur du poste électrique 100.

La tension de synchronisation est une tension en phase ou présentant un déphasage constant avec la haute tension du poste électrique 100. Ainsi la tension de synchronisation peut être une tension du poste électrique 100 dont la source peut être choisie dans le groupe comportant un transformateur inductif du poste électrique 100, un capteur capacitif du poste électrique 100 et une alimentation basse tension d'une sous-station du poste électrique 100.

Chacun des capteurs 150, 300, qu'il soit interne ou externe, peut être une antenne monopole. Dans le cas d'un capteur intérieur 150, chaque antenne monopole est préférentiellement montée à demeure dans l'enceinte 125 correspondante.

Le dispositif de contrôle 400 comprend, comme illustré sur la figure 2:
- un boîtier 405,
- trois bornes de connexion 411 à un capteur 150, 300,
- des bornes de synchronisation 412 pour connecter le dispositif de contrôle 400 à une tension de synchronisation,
- une prise informatique 413 pour connecter un ordinateur 500,
- et une prise de mise à la terre 414 pour assurer la sécurisation du dispositif de contrôle 400.

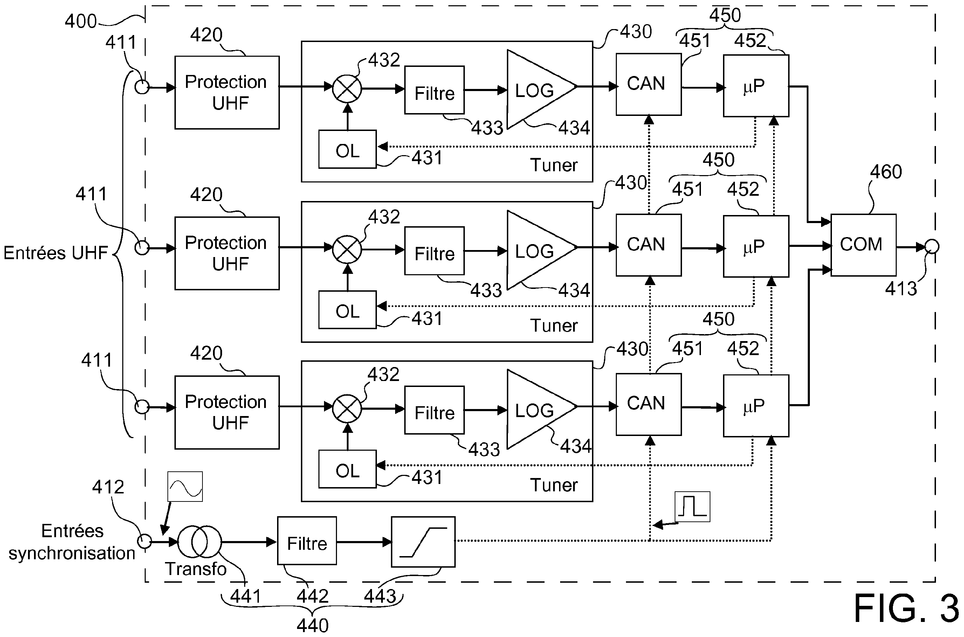

Selon le schéma fonctionnel de la figure 3, le dispositif de contrôle 400 comprend en outre :
- trois systèmes de protection UHF 420 dont les entrées sont chacune reliées à l'une des bornes de connexion 411,
- trois tuners UHF 430 dont les entrées sont chacune reliées à la sortie de l'un des systèmes de protection UHF 420,
- trois convertisseurs analogiques/numériques (ou CAN) 451 dont les entrées sont chacune reliées à la sortie de l'un des tuners UHF de manière à convertir les signaux issus du tuner UHF 430 correspondant en signal numérique,
- un système d'acquisition 440 d'une tension de synchronisation, dont l'entrée est reliée à la borne de synchronisation 412,
- trois unités de traitement 452 (ou µP) synchronisées par le système d'acquisition 440 d'une tension de synchronisation et chacune adaptée pour traiter les signaux numériques issus d'un convertisseur analogique/numérique 451, également synchronisé par le système d'acquisition 440,
- un module de connexion 460 (ou COM) à un ordinateur 500, le dit module de connexion 460 étant adapté pour faire interface entre les unités de traitement 452 et l'ordinateur 500, et étant relié à la prise informatique 413 du dispositif de contrôle 400 de manière à ce que le module de connexion puisse être connecté à un ordinateur 500.

Pour faciliter sa manipulation, le boîtier 405 du dispositif de contrôle 400 peut être, comme illustré sur les figures 1 et 2, une valise. Selon cette possibilité, le boîtier 405 présente sur sa face intérieure 406 les bornes de connexion 411, les bornes de synchronisation 412, la prise informatique 413 et la prise de mise à la terre 414.

Les bornes de connexion 411 peuvent être des entrées adaptées pour connecter un câble coaxial 310 à faible perte connecté à un capteur 150, 300.

Les bornes de connexion 411 forment chacune un moyen de connexion pour connecter un capteur 150, 300.

Chacune des bornes de connexion 411 est reliée à un système de protection UHF 420 qui permet de d'éliminer les surtensions transitoires venant du capteur 150, 300 relié à la dite borne de connexion 411. Un tel système de protection est particulièrement avantageux pour une borne de connexion 411 reliée à un capteur intérieur 150 qui est donc soumis aux surtensions souvent présentes dans un poste électrique.

Chacun des systèmes de protection UHF 420 est relié à un des tuners UHF 430. Chaque tuner UHF 430 est un tuner de type hétérodyne, c'est-à-dire qu'il comprend :
- un oscillateur local 431 (ou OL) adapté pour générer un signal oscillant à une fréquence variable,
- un mélangeur 432 dont une des entrées est reliée à la sortie du système de protection UHF 420 et l'autre à l'oscillateur local 431,
- un filtre en fréquence 433 (ou Filtre) de type passe bande adapté pour filtrer les signaux issus du mélangeur dont la fréquence n'est pas comprise dans une bande de fréquence centrée autour d'une fréquence prédéterminée,
- un amplificateur logarithmique 434 (ou LOG) branché à la sortie du filtre en fréquence 433.

Un tel tuner UHF 430 fonctionne selon le principe du tuner hétérodyne consistant à décaler les signaux en entrée d'une fréquence définie par oscillateur local 431 et à filtrer les signaux ainsi décalés par le filtre en fréquence 433. Selon ce principe la sélection de la bande de fréquence mesurée est obtenue par la modification de la fréquence de modulation de l'oscillateur local 431. Les signaux ainsi filtrés sont ensuite amplifiés par l'amplificateur logarithmique 434. Ce principe étant connu par ailleurs, il n'est pas décrit plus en avant dans ce document.

Le tuner UHF est préférentiellement adapté pour fonctionner sur une plage de fréquence de 300 à 1200 MHz. La bande de fréquence du filtre en fréquence 431 est inférieure à 10 MHz et préférentiellement égale 3 MHz.

Chacun des tuners UHF 430 est relié à un des convertisseurs analogiques/numériques 451 de manière à permettre un traitement numérique des signaux issus de chacun des tuners UHF 430. Après numérisation des signaux, ceux-ci sont transmis sous forme numérique à une unité de traitement 452 dédiée.

Chaque tuner UHF 430 forme un moyen d'acquisition adapté pour acquérir les signaux reçus par un capteur 150, 300.

Chacune des unités de traitement 452 est en outre reliée au système d'acquisition 440 d'une tension de synchronisation reliée à la borne de synchronisation 412.

Ce système d'acquisition 440 d'une tension de synchronisation comprend :
- un transformateur 441 permettant un abaissement de la tension de synchronisation de manière à autoriser son traitement par le dispositif de contrôle 400,
- un filtre passe bande 442,
- et un système de synchronisation 443 adapté pour déterminer au moins la phase de la tension de synchronisation et transmettre une pulsation synchronisée à partir de la phase de la tension de synchronisation aux unités de traitement 452 et au convertisseur analogiques/numériques 451.

On entend donc par acquisition de la variation temporelle de la tension de synchronisation l'acquisition d'au moins la phase de la tension de synchronisation, la fréquence de celle-ci pouvant être connue par ailleurs, la phase peut donc être suffisante pour reconstituer le signal de la tension de synchronisation.

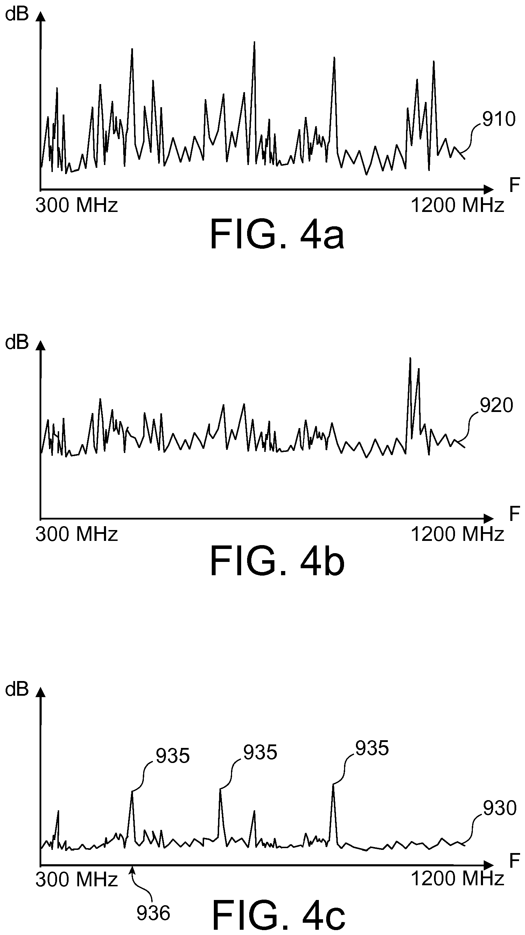

L'unité de traitement 452 est en outre adaptée pour faire varier la fréquence de l'oscillateur local 431 du Tuner UHF 430 correspondant, ceci pour permettre à la fois l'acquisition d'un spectre en fréquence sur une plage de fréquence UHF et l'acquisition de la variation temporelle des signaux pour une bande fréquence fixe centrée autour d'une fréquence d'acquisition 936 (voir figure 4c).

Chaque unité de traitement 452, avec le convertisseur analogiques/numériques 451 correspondant, forme un moyen de traitement 450

Chacune des unités de traitement 452 est reliée au module de connexion 460 et est adaptée pour être contrôlée par un ordinateur 500 et permettre de réaliser le procédé de contrôle.

Le module de connexion 460, avec la prise informatique 413, forme un moyen de connexion informatique.

Ainsi après branchement du dispositif de contrôle 400 aux capteurs internes 150 de l'élément 101 de poste électrique 100, à un capteur externe 300, à la tension de synchronisation et à un ordinateur 500 équipé d'un programme d'ordinateur adéquat, le dispositif de contrôle 400 permet un contrôle de l'état du poste électrique 100 selon le procédé de contrôle d'un poste électrique 100.

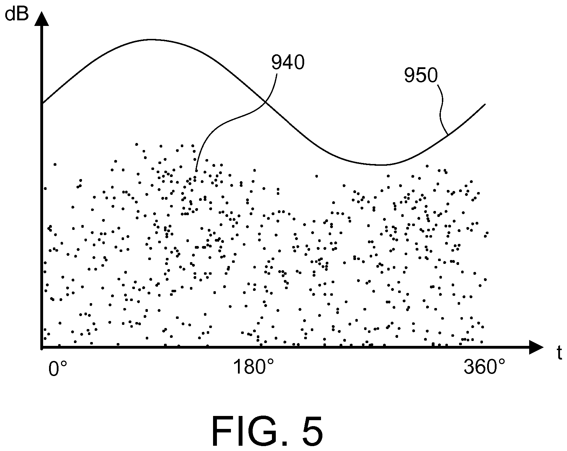

Ce procédé de contrôle d'un poste électrique comporte les étapes consistant à :
a) acquérir, sur la plage de fréquence UHF et par le dispositif de contrôle 400, sensiblement parallèlement au moins un premier spectre 910 en fréquence, tel que celui illustré sur la figure 4a, des signaux reçus par un capteur interne 150 et au moins un deuxième spectre 920 en fréquence, tel que celui illustré sur la figure 4b, des signaux reçus par un capteur externe 300 au poste électrique 100,
   a*) transmettre, par le dispositif de contrôle 400, à l'ordinateur 500 les spectres 910, 920 en fréquence acquis lors de l'étape a)
b) calculer, par ordinateur 500, un spectre en fréquence du rapport signal sur bruit 930, tel que celui illustré sur la figure 4c, à partir du premier spectre 910 et du deuxième spectre 920, le premier spectre 910 correspondant au signal et le deuxième spectre 920 correspondant au bruit,
c) déterminer, par l'utilisateur assisté par l'ordinateur 500, dans la plage de fréquence la présence d'un maximum 935 du rapport signal sur bruit signature de la présence d'au moins une décharge partielle.
   c*) Si aucun maximum 935 du rapport signal sur bruit significatif n'est détecté, arrêter le procédé et en conclure le bon fonctionnement du poste électrique 100 contrôlé,
d) Si au moins un maximum 935 du rapport signal sur bruit est détecté, sélectionner, par l'utilisateur assisté par l'ordinateur 500, une fréquence d'acquisition 936 correspondant à l'un des maximums 935 du rapport signal sur bruit détectés lors de l'étape c),
e) Acquérir, par le dispositif de contrôle 400 et à partir d'un capteur interne 150, la variation temporelle 940 (voir la figure 5) des signaux dans une bande de fréquence centrée autour de la fréquence d'acquisition 936,
f) Comparer, par l'utilisateur et lors d'un affichage sur l'ordinateur 500, ladite variation temporelle 940 avec variation temporelle d'une tension de synchronisation 950 (voir la figure 5) du poste électrique 100.

L'étape e) peut être acquise sur un temps donné multiple de la période de la tension de synchronisation, ainsi la comparaison réalisée sur l'étape e) peut être matérialisée, comme illustré sur la figure 5, par un affichage de la variation de la tension de synchronisation, sur une seule de ses périodes, sur laquelle est superposée la variation du signal acquis pendant l'étape en f) sur plusieurs périodes du signal de synchronisation.

Certaines étapes de ce procédé sont mises en œuvre par un programme d'ordinateur qui, lorsqu'il est exécuté par un ordinateur 500 branché au dispositif de contrôle 400, réalise les fonctions consistant à :
a') commander deux unités de traitement 452 pour faire une acquisition parallèle par les deux tuners UHF 430 correspondant de deux spectres de fréquence 910, 920 des signaux reçus par deux des capteurs correspondant 150, 300, un des deux capteurs 150, 300 correspondant étant un capteur interne 150 du poste électrique 100 et l'autre capteur correspondant 300 étant un capteur externe 300,
b') calculer un spectre en fréquence du rapport signal sur bruit 930 à partir des spectres 910, 920 acquis par les deux unités de traitement 452 pendant l'étape a'),
c') afficher par l'ordinateur 500 ledit spectre du rapport signal sur bruit 930,
d') attendre que l'utilisateur confirme la présence d'au moins un maximum 935 du rapport signal sur bruit signature de la présence d'au moins une décharge partielle, et que l'utilisateur sélectionne la fréquence d'acquisition 936 correspondant à un maximum 935 du rapport signal sur bruit,
e') commander l'unité de traitement 452 correspondant au capteur interne 150 pour faire une acquisition, pendant une durée donnée et dans une bande fréquence centrée autour de la fréquence d'acquisition 936, par le tuner UHF 430 correspondant des signaux reçus par le capteur correspondant 150, l'unité de traitement 452 étant en outre commandée pour faire acquérir sensiblement simultanément la variation temporelle de la tension de synchronisation par le système d'acquisition,
f') afficher un graphique présentant une variation temporelle comparée entre les signaux acquis par l'au moins un moyen d'acquisition à l'étape e') et la tension de synchronisation acquise à l'étape e').
le programme d'ordinateur est en outre adapté pour, lorsqu'il est exécuté par un ordinateur 500 branché au dispositif de contrôle 400, réaliser les fonctions consistant à faire une acquisition successive, par l'une des unités de traitement 452, de spectres en fréquence des signaux d'au moins un des capteurs 150, 300 et afficher à l'écran sur demande de l'utilisateur le dernier spectre en fréquence des signaux enregistrés, un spectre moyenné sur les n derniers spectres et un spectre des amplitudes maximales des signaux enregistrés lors des acquisitions successives

Si dans le mode de réalisation décrit ci-dessus le dispositif de contrôle 400 présente un système d'acquisition comportant trois circuits d'acquisition des signaux issus de capteur 150, 300 comportant chacun une borne de connexion 411, un système de protection UHF 420, un tuner UHF 430, un convertisseur analogique/numérique 451 et une unité de traitement 452, le dispositif peut comporter seulement deux circuits d'acquisition, l'un pour un capteur interne 150 et l'autre pour un capteur externe 300 ou plus de trois circuits d'acquisition, sans que l'on sorte du cadre de l'invention.

De même, si dans le mode de réalisation décrit ci-dessus, le dispositif de contrôle 400 comporte une unité de traitement 452 dédiée pour chacun des tuners UHF 430, le dispositif peut comporter une seule et unique unité de traitement 452 adaptée pour traiter les signaux issus de l'ensemble des tuners UHF 430 sans que l'on sorte du cadre de l'invention.

Selon une variante non représentée sur les dessins, le dispositif de contrôle 400 peut être adapté de manière à ce que les étapes mises en œuvre par un ordinateur 500 soient directement réalisées par les unités de traitement 452. Selon cette possibilité, le dispositif de contrôle 400 comprend en outre un système d'affichage et des moyens de commande pour permettre une interaction avec l'utilisateur dudit dispositif de contrôle 400.

De même si dans l'exemple de mise en œuvre du procédé de contrôle décrit ci-dessus, ce procédé est mis en œuvre sur un élément 101 de poste électrique 100, ce procédé est adapté pour être mis en œuvre sur tout type et partie de poste électrique 100 à haute tension isolé au gaz pouvant comporter un capteur interne 150.

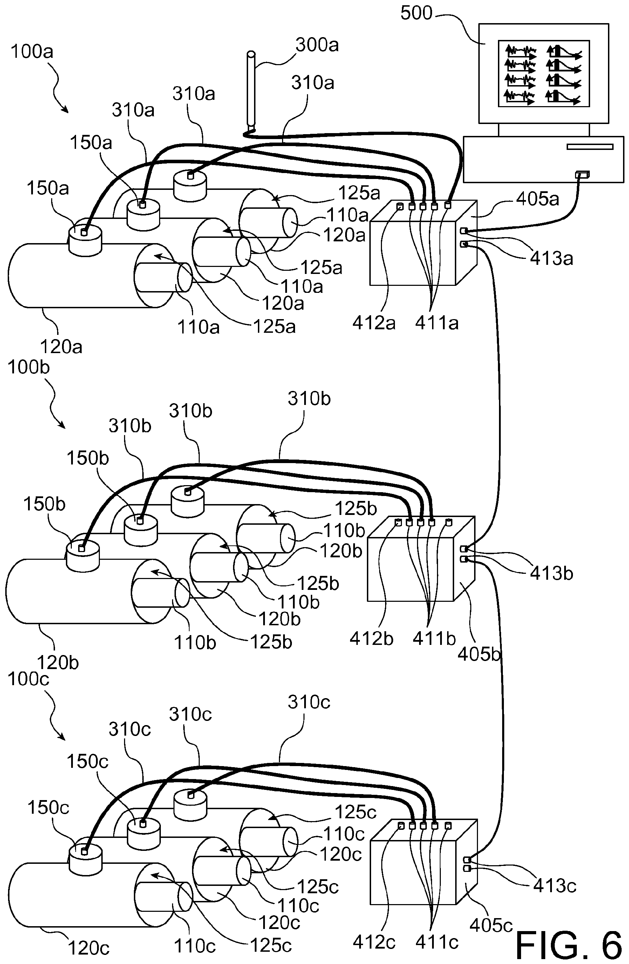

De même si dans l'exemple de mise en œuvre du dispositif de contrôle 400 décrit ci-dessus, le boîtier 405 est portatif et est destiné à être connecté manuellement par un opérateur aux différents capteurs internes 150 du poste électrique 100, il est possible d'envisager, comme illustré sur la figure 6, une installation à demeure sans que l'on sorte du cadre de l'invention. Selon cette possibilité, une telle installation peut comporter préférentiellement plusieurs boîtiers 405a,b,c équipant chacun une partie 100a,b,c d'un poste électrique 100, chacun de ces boîtiers 405a,b,c étant connecté à un ordinateur 500 distant via une connexion informatique ou un réseau informatique. Avec ce type d'installation, un seul capteur extérieur 300a commun à l'ensemble des parties du poste électrique est nécessaire pour mesurer le bruit extérieur, ce bruit variant peu sur l'ensemble d'un poste électrique 100. Selon cette même possibilité, les boîtiers se présentent sous une forme compatible avec une installation à demeure, telle que sous la forme, comme illustré sur la figure 6, d'un boîtier sensiblement parallélépipédique avec les bornes de connexion 411a,b,c et de synchronisation 412a,b,c et la/ou les prises informatiques accessibles à la surface du boîtier.

## Revendications

1. Procédé de contrôle d'un poste électrique (100) haute tension isolé au gaz, ledit poste électrique (100) comportant au moins un capteur interne (150) adapté pour mesurer des ondes électromagnétiques Ultra Haute Fréquence (UHF), le procédé étant **caractérisé en ce qu'**il comporte les étapes consistant à :
a) acquérir parallèlement au moins un premier spectre (910) en fréquence des signaux reçus par l'au moins un capteur interne (150) et au moins un deuxième spectre (920) en fréquence des signaux reçus par au moins un capteur externe (300) au poste électrique (100), l'au moins un premier spectre (910) et l'au moins un deuxième spectre (920) étant acquis sur une plage de fréquence UHF,
b) calculer un spectre en fréquence du rapport signal sur bruit (930) à partir du au moins un premier spectre (910) et l'au moins un deuxième spectre (920), l'au moins un premier spectre (910) correspondant au signal et l'au moins un deuxième spectre (920) correspondant au bruit,
c) déterminer dans la plage de fréquence la présence d'au moins un maximum (935) du rapport signal sur bruit, signature de la présence d'au moins une décharge partielle.

2. Procédé selon la revendication 1, dans lequel le procédé comprend en outre après l'étape c), les étapes consistant à :
d) sélectionner une fréquence d'acquisition (936) correspondant à l'un des maximums (935) de signal sur bruit détectés lors de l'étape c),
e) acquérir à partir de l'au moins un capteur interne (150) la variation temporelle (940) des signaux dans une bande de fréquence centrée autour de la fréquence d'acquisition (936),
f) comparer ladite variation temporelle (940) avec une variation temporelle d'une tension de synchronisation (950) du poste électrique (100).

3. Procédé selon la revendication 1 ou 2, dans lequel la plage de fréquence présente des bornes inférieure et supérieure comprises entre 200 MHz et 3 GHz et préférentiellement comprises entre 300 MHz et 1200 MHz.

4. Procédé selon la revendication 2 ou la revendication 3 en combinaison avec la revendication 2, dans lequel la bande de fréquence possède une largeur de bande inférieure ou égale à 10 MHz et préférentiellement inférieure ou égale à 3 MHz.

5. Procédé selon la revendication 2 ou l'une des revendication 3 à 4 en combinaison avec la revendication 2, dans lequel la tension de synchronisation est une tension dont la source est choisie dans le groupe comportant un transformateur inductif du poste électrique (100), un capteur capacitif du poste électrique (100) et une alimentation basse tension d'une sous-station du poste électrique (100).

6. Dispositif de contrôle (400) d'un poste électrique (100) haute tension isolé au gaz, ledit dispositif de contrôle (400) étant **caractérisé en ce** qu'il est adapté pour la mise en œuvre d'un procédé selon l'une quelconque des revendications précédentes et en ce qu'il comporte :
- au moins deux moyens de connexion chacun destiné à être connecté à un capteur (150, 300), l'un étant destiné à être connecté à un capteur interne (150) d'un poste électrique (100), l'autre étant destiné à être connecté à un capteur externe (300),
- au moins deux moyens d'acquisition de signaux chacun adapté pour acquérir un signal reçu par un capteur (150, 300) connecté à un moyen de connexion correspondant audit moyen d'acquisition,
- au moins un moyen de traitement (450) des signaux acquis par au moins un des au moins deux moyens d'acquisition, l'au moins un moyen de traitement (450) étant en outre adapté pour commander ledit ou lesdits moyens d'acquisition de signaux
chacun des moyens d'acquisition comprenant un tuner UHF (430) adapté pour acquérir des signaux UHF sur une bande de fréquence variable, le tuner UHF (430) étant en outre adapté pour balayer la bande de fréquence variable sur une plage de fréquence UHF.

7. Dispositif de contrôle (400) selon la revendication 6, dans lequel le dispositif de contrôle (400) comprend en outre au moins un moyen d'acquisition d'une tension de synchronisation, l'au moins un moyen de traitement (450) étant en outre adapté pour communiquer avec le moyen d'acquisition d'une tension de synchronisation.

8. Dispositif de contrôle (400) selon la revendication 6 ou 7, dans lequel le dispositif de contrôle (400) comprend au moins deux moyens de traitement (450) adaptés chacun pour traiter des signaux de l'un des au moins deux moyens d'acquisition.

9. Dispositif de contrôle (400) selon l'une quelconque des revendications 6 à 8, dans lequel, chaque tuner UHF (430) est un tuner du type hétérodyne.

10. Dispositif de contrôle (400) selon l'une des revendications 6 à 9, dans lequel le dispositif de contrôle (400) comporte en outre un moyen de connexion informatique adapté pour connecter l'au moins un moyen de traitement (450) avec un ordinateur (500), le au moins un moyen de traitement (450) étant adapté pour être contrôlé par un ordinateur (500).

11. Procédé mis en œuvre par un ordinateur (500) pour contrôler un poste électrique (100) haute tension isolé au gaz, **caractérisé en ce que** ledit ordinateur (500) est, lors de la mise en œuvre du procédé, connecté à un dispositif de contrôle (400) selon l'une quelconque des revendications 6 à 8, ledit procédé comportant les étapes consistant à :
a') commander l'au moins un moyen de traitement (450) pour faire l'acquisition d'au moins un premier spectre (910) en fréquence par au moins un des au moins deux moyens d'acquisition de signaux des signaux reçus par au moins un capteur correspondant (150), le au moins un capteur correspondant (150) étant au moins un capteur interne (150) d'un poste électrique (100), et commander l'au moins un moyen de traitement (150) pour faire l'acquisition, simultanément à l'acquisition du au moins un premier spectre (910), d'au moins un deuxième spectre (920) en fréquence par au moins un autre des au moins deux moyens d'acquisition de signaux des signaux reçus par au moins un autre capteur correspondant (300) au au moins un autre des au moins deux moyens d'acquisition de signaux, ledit au moins un autre capteur correspondant (300) étant un capteur externe (300),
b') calculer un spectre en fréquence du rapport signal sur bruit (930) à partir des spectres (910, 920) acquis par les au moins deux moyens d'acquisition de signaux pendant l'étape a'),
c') afficher à l'écran ledit spectre en fréquence du rapport signal sur bruit (930) pour permettre à un utilisateur de déterminer dans la plage de fréquence la présence d'au moins un maximum (935) du rapport signal sur bruit, signature de la présence d'au moins une décharge partielle.

12. Procédé mis en œuvre par un ordinateur (500) selon la revendication 11, dans lequel le procédé comprend en outre après l'étape c') les étapes consistant à :
d') attendre que l'utilisateur sélectionne une fréquence d'acquisition (936) correspondant à un maximum (935) du rapport signal sur bruit,
e') commander l'au moins un moyen de traitement (450) pour faire une acquisition, pendant une durée donnée et dans une bande fréquence centrée autour de la fréquence d'acquisition (936), par au moins un des aux moins deux moyens d'acquisition de signaux des signaux reçus par le au moins un capteur correspondant (150), le au moins un capteur correspondant (150) à l'au moins un des au moins deux moyens d'acquisition étant au moins un capteur interne (150) du poste électrique (100), l'au moins un moyen de traitement étant en outre commandé pour faire acquérir simultanément la variation temporelle de la tension de synchronisation par le moyen d'acquisition de la tension de synchronisation,
f') afficher un graphique présentant une variation temporelle comparée entre les signaux acquis par l'au moins un moyen d'acquisition à l'étape e') et la tension de synchronisation acquise à l'étape e').

13. Procédé mis en œuvre par un ordinateur (500) selon la revendication 11 ou 12, dans lequel, ledit procédé est adapté en outre pour faire une acquisition successive de spectres en fréquence des signaux d'au moins un des capteurs et afficher à l'écran sur demande de l'utilisateur le dernier spectre en fréquence des signaux enregistrés, un spectre moyenné sur les n derniers spectres et un spectre des amplitudes maximales des signaux enregistrés lors des acquisitions successives.

## Patentansprüche

1. Verfahren zur Steuerung einer gasisolierten elektrischen Hochspannungsschaltanlage (100), wobei die elektrische Schaltanlage (100) mindestens einen internen Sensor (150) umfasst, der zum Messen der elektromagnetischen Ultrahochfrequenzwellen (UHF), angepasst ist, wobei das Verfahren **dadurch gekennzeichnet ist, dass** es die Schritte umfasst, bestehend aus:
a) parallel Erfassen von mindestens einem Frequenzspektrum (910) der von dem mindestens einen internen Sensor (150) empfangenen Signale und mindestens einem zweiten Frequenzspektrum (920) der durch mindestens einen externen Sensor (300) empfangenen Signale an der elektrischen Schaltanlage (100), wobei das mindestens eine erste Spektrum (910) und das mindestens eine zweite Spektrum (920) in einem UHF-Frequenzbereich erfasst werden,
b) Berechnen eines Frequenzspektrums des Verhältnisses Signal zu Geräusch (930) aus dem mindestens einen ersten Spektrum (910) und dem mindestens einen zweiten Spektrum (920), wobei das mindestens eine erste Spektrum (910) dem Signal entspricht und das mindestens eine zweite Spektrum (920) dem Geräusch entspricht,
c) Bestimmen in dem Frequenzbereich des Vorhandenseins mindestens eines Maximums (935) des Verhältnisses Signal zu Geräusch, Signatur für das Vorhandensein mindestens einer Teilentladung.

2. Verfahren nach Anspruch 1, wobei das Verfahren weiter nach dem Schritt c), die Schritte umfasst, bestehend aus:
d) Auswählen einer Erfassungsfrequenz (936) entsprechend einem der Maxima (935) eines Signals zu Geräusch, die im Schritt c) erkannt werden,
e) Erfassen aus dem mindestens einen internen Sensor (150) der Zeitabweichung (940) der Signale in einem Frequenzband, das um die Erfassungsfrequenz (936) zentriert ist,
f) Vergleichen der Zeitabweichung (940) mit einer Zeitabweichung einer Synchronisationsspannung (950) der elektrischen Schaltanlage (100).

3. Verfahren nach Anspruch 1 oder 2, wobei der Frequenzbereich eine untere und obere Klemme aufweist, die zwischen 200 MHz und 3 GHz liegen, und vorzugsweise zwischen 300 MHz und 1200 MHz liegen.

4. Verfahren nach Anspruch 2 oder Anspruch 3 in Verbindung mit Anspruch 2, wobei das Frequenzband eine Bandbreite kleiner oder gleich 10 MHz und vorzugsweise kleiner oder gleich 3 MHz besitzt.

5. Verfahren nach Anspruch 2 oder einem der Ansprüche 3 bis 4 in Verbindung mit Anspruch 2, wobei die Synchronisationsspannung eine Spannung ist, deren Quelle aus der Gruppe ausgewählt ist, die einen induktiven Transformator der elektrischen Schaltanlage (100), einen kapazitiven Sensor der elektrischen Schaltanlage (100) und eine Niederspannungsversorgung einer Teilstation der elektrischen Schaltanlage (100) umfasst.

6. Vorrichtung zur Steuerung (400) einer gasisolierten elektrischen Hochspannungsschaltanlage (100), wobei die Vorrichtung zur Steuerung (400) **dadurch gekennzeichnet ist, dass** sie zur Umsetzung eines Verfahrens nach einem der vorstehenden Ansprüche angepasst ist, und dadurch, dass sie umfasst:
- mindestens zwei Verbindungsmittel, von denen jedes dazu bestimmt ist, mit einem Sensor (150, 300) verbunden zu werden, von denen einer dazu bestimmt ist, mit einem internen Sensor (150) einer elektrischen Schaltanlage (100) verbunden zu werden, der andere dazu bestimmt ist, mit einem externen Sensor (300) verbunden zu werden,
- mindestens zwei Mittel zum Erfassen von Signalen, jedes davon angepasst, um ein Signal zu erfassen, das von einem Sensor (150, 300) empfangen wird, der mit einem Mittel zum Verbinden verbunden ist, das dem Erfassungsmittel entspricht,
- mindestens ein Verarbeitungsmittel (450) der Signale, die durch mindestens eines der mindestens zwei Erfassungsmittel erfasst werden, wobei das mindestens eine Verarbeitungsmittel (450) weiter angepasst ist, um den oder die Signalerfassungsmittel zu steuern
wobei jedes der Erfassungsmittel einen UHF-Tuner (430) umfasst, der angepasst ist, um UHF-Signale in einem variablen Frequenzband zu erfassen, wobei der UHF-Tuner (430) weiter angepasst ist, um das variable Frequenzband in einem UHF-Frequenzbereich abzutasten.

7. Vorrichtung zur Steuerung (400) nach Anspruch 6, wobei die Vorrichtung zur Steuerung (400) weiter mindestens ein Erfassungsmittel einer Synchronisationsspannung umfasst, wobei das mindestens eine Verarbeitungsmittel (450) weiter angepasst ist, um mit dem Erfassungsmittel einer Synchronisationsspannung zu kommunizieren.

8. Vorrichtung zur Steuerung (400) nach Anspruch 6 oder 7, wobei die Vorrichtung zur Steuerung (400) mindestens zwei Verarbeitungsmittel (450) umfasst, die jeweils angepasst sind, um Signale des einen der mindestens zwei Erfassungsmittel zu verarbeiten.

9. Vorrichtung zur Steuerung (400) nach einem der Ansprüche 6 bis 8, wobei jeder UHF-Tuner (430) ein Tuner in der Art eines Aufwärtswandlers ist.

10. Vorrichtung zur Steuerung (400) nach einem der Ansprüche 6 bis 9, wobei die Vorrichtung zur Steuerung (400) weiter ein Computerverbindungsmittel umfasst, das angepasst ist, um das mindestens eine Verarbeitungsmittel (450) mit einem Computer (500) zu verbinden, wobei das mindestens eine Verarbeitungsmittel (450) angepasst ist, um von einem Computer (500) gesteuert zu werden.

11. Verfahren, das von einem Computer (500) umgesetzt wird, um eine gasisolierte elektrische Hochspannungsschaltanlage (100) zu steuern, **dadurch gekennzeichnet, dass** der Computer (500) beim Umsetzen des Verfahrens mit einer Vorrichtung zum Steuern (400) nach einem der Ansprüche 6 bis 8 verbunden ist, wobei das Verfahren die Schritte umfasst, bestehend aus:
a') Steuern des mindestens einen Verarbeitungsmittels (450) zum Erfassen lassen mindestens eines ersten Frequenzspektrums (910) durch mindestens eines der beiden Signalerfassungsmittel der Signale, die von mindestens einem entsprechenden Sensor (150) empfangen werden, wobei der mindestens eine entsprechende Sensor (150) mindestens ein interner Sensor (150) einer elektrischen Schaltanlage(100) ist, und Steuern des mindestens einen Verarbeitungsmittels (150) um gleichzeitig mit der Erfassung des mindestens einen Spektrums (910) mindestens ein zweites Frequenzspektrum (920) durch mindestens ein anderes der mindestens zwei Signalerfassungsmittel Signale erfassen zu lassen, die durch mindestens einen anderen entsprechenden Sensor (300) erfasst werden, an dem mindestens einen anderen der mindestens zwei Signalerfassungsmittel, wobei der mindestens eine andere entsprechende Sensor (300) ein externer Sensor (300) ist
b') Berechnen eines Frequenzspektrums des Verhältnisses Signal zu Geräusch (930) aus Spektren (910, 920), die durch die mindestens zwei Signalerfassungsmittel im Schritt a') erfasst werden,
c') Anzeigen am Bildschirm des Frequenzspektrums des Verhältnisses Signal zu Geräusch (930), um es einem Nutzer zu ermöglichen, in dem Frequenzbereich das Vorhandensein mindestens eines Maximums (935) des Verhältnisses Signal zu Geräusch, Signatur für das Vorhandensein mindestens einer Teilentladung, zu bestimmen.

12. Verfahren, das durch einen Computer (500) umgesetzt wird, nach Anspruch 11, wobei das Verfahren weiter nach dem Schritt c') die Schritte umfasst, bestehend aus:
d') Warten, bis der Nutzer eine Erfassungsfrequenz (936) entsprechend dem Maximum (935) des Verhältnisses Signal zu Geräusch auswählt,
e') Steuern des mindestens einen Verarbeitungsmittels (450) zum Erfassen lassen, während einer gegebenen Dauer und in einem Frequenzband, das um die Erfassungsfrequenz (936) zentriert ist, durch mindestens eines der mindestens zwei Signalerfassungsmittel der Signale, die durch den mindestens einen entsprechenden Sensor (150) empfangen werden, wobei der mindestens eine entsprechende Sensor (150) des mindestens einen der mindestens zwei Erfassungsmittel mindestens ein interner Sensor (150) der elektrischen Schaltanlage (100) ist, wobei das mindestens eine Verarbeitungsmittel weiter gesteuert ist, um gleichzeitig die Zeitabweichung der Synchronisationsspannung durch das Erfassungsmittel der Synchronisationsspannung erfassen zu lassen,
f') Anzeigen einer Grafik, die eine Zeitabweichung aufweist, die zwischen den durch das mindestens eine Erfassungsmittel im Schritt e') erfassten Signale und der im Schritt e') erfassten Synchronisationsspannung verglichen wird.

13. Verfahren, das von einem Computer (500) umgesetzt wird, nach Anspruch 11 oder 12, wobei das Verfahren weiter angepasst ist, um eine aufeinanderfolgende Erfassung von Frequenzspektren der Signale mindestens eines der Sensoren zu machen, und am Bildschirm auf Anfrage des Nutzers das letzte Frequenzspektrum der gespeicherten Signale, ein gemitteltes Spektrum der letzten n Spektren und ein Spektrum der maximalen Amplituden der gespeicherten Signale bei den aufeinanderfolgenden Erfassungen anzuzeigen.

## Claims

1. Method for controlling a gas-insulated high-voltage electrical station (100), said electrical station (100) including at least one internal sensor (150) suitable for measuring Ultra High Frequency (UHF) electromagnetic waves, the method being **characterised in that** it includes steps consisting of:
a) acquiring in parallel at least one first frequency spectrum (910) of the signals received by the at least one internal sensor (150) and at least one second frequency spectrum (920) of the signals received by at least one external sensor (300) at the electrical station (100), the at least one first spectrum (910) and the at least one second spectrum (920) being acquired over a UHF frequency range,
b) calculating a frequency spectrum of the signal-to-noise ratio (930) from the at least one first spectrum, (910) and the at least one second spectrum (920), the at least one first spectrum, (910) corresponding to the signal and the at least one second spectrum (920) corresponding to the noise,
c) determining in the frequency range the presence of at least one maximum (935) of the signal-to-noise ratio, which is a signature of the presence of at least one partial discharge.

2. Method according to claim 1, wherein the method further comprises after step c), the steps consisting of:
d) selecting an acquisition frequency (936) corresponding to one of the signal-to-noise maxima (935) detected in step c),
e) acquiring from the at least one internal sensor (150) the time variation (940) of signals in a frequency band centred around the acquisition frequency (936),
f) comparing said time variation (940) with a time variation of a synchronisation voltage (950) of the electrical station (100).

3. Method according to claim 1 or 2, wherein the frequency range has lower and upper limits between 200 MHz and 3 GHz and preferably between 300 MHz and 1200 MHz.

4. Method according to claim 2 or claim 3 in combination with claim 2, wherein the frequency band has a bandwidth of 10 MHz or less and preferably 3 MHz or less.

5. Method according to claim 2 or any of claims 3 to 4 in combination with claim 2, wherein the synchronisation voltage is a voltage whose source is selected from the group including an inductive transformer of the electrical station (100), a capacitive sensor of the electrical station (100) and a low voltage supply of a substation of the electrical station (100).

6. Control device (400) for a gas-insulated high-voltage electrical station (100), said control device (400) being **characterised in that** it is suitable for executing a method according to any of the preceding claims and **in that** it includes:
- at least two connecting means each intended for connection to a sensor (150, 300), one for connecting to an internal sensor (150) of an electrical station (100), the other being for connecting to an external sensor (300),
- at least two signal acquisition means, each suitable for acquiring a signal received by a sensor (150, 300) connected to a connecting means corresponding to said acquisition means,
- at least one means for processing (450) the signals acquired by at least one of the at least two acquisition means, the at least one processing means (450) being further suitable for controlling said acquisition means,
each of the acquisition means comprising an UHF tuner (430) suitable for acquiring UHF signals over a variable frequency band, the UHF tuner (430) being further suitable for scanning the variable frequency band over a UHF frequency range.

7. Control device (400) according to claim 6, wherein the control device (400) further comprises at least one synchronisation voltage acquisition means, the at least one processing means (450) being further suitable for communicating with the synchronisation voltage acquisition means.

8. Control device (400) according to claim 6 or 7, wherein the control device (400) comprises a least two processing means (450) each suitable for processing signals from one of the at least two acquisition means.

9. Control device (400) according to any of claims 6 to 8, wherein each UHF tuner (430) is a heterodyne type tuner.

10. Control device (400) according to any of claims 6 to 9, wherein the control device (400) further includes a computer connecting means suitable for connecting the at least one processing means (450) with a computer (500), the at least one processing means (450) being suitable for control by a computer (500).

11. Method executed by a computer (500) for controlling a gas-insulated high-voltage electrical station (100), **characterised in that** said computer (500) is connected, during the execution of the method, to a control device (400) according to any of claims 6 to 8, said method comprising the steps of:
a') controlling the at least one processing means (450) to acquire at least one first frequency spectrum (910) by at least one of the at least two signal acquisition means of signals received by at least one corresponding sensor (150), the at least one corresponding sensor (150) being at least one internal sensor (150) of an electrical station (100), and controlling the at least one processing means (150) to acquire, simultaneously with the acquisition of the at least one first spectrum (910), at least one second frequency spectrum (920) by at least one other of the at least two signal acquisition means of signals received by at least one other sensor (300) corresponding to at least one other of the at least two signal acquisition means, the said at least one other corresponding sensor (300) being an external sensor (300),
b') calculating a signal-to-noise ratio frequency spectrum (930) from the spectra (910, 920) acquired by the at least two signal acquisition means during steps a'),
c') displaying said signal-to-noise ratio frequency spectrum (930) on the screen to enable a user to determine the presence of at least one signal-to-noise ratio maximum (935) in the frequency range, signature of the presence of at least one partial discharge.

12. Method executed by a computer (500) according to claim 11, wherein the method further comprises after step c') steps consisting of:
d') waiting for the user to select an acquisition frequency (939) corresponding to a maximum (935) of the signal-to-noise ratio,
e') controlling the at least one processing means (450) to make an acquisition, during a given period and in a frequency band centred around the acquisition frequency (936), by at least one of the a least two signal acquisition means of signals received by the corresponding at least one sensor (150), the at least one sensor corresponding (150) to the at least one of the at least two acquisition means being at least an internal sensor (150) of the electrical station (100), the at least one processing means being further controlled to simultaneously acquire the time variation of the synchronisation voltage by the synchronisation voltage acquisition means,
f') displaying a graph showing a comparative time variation between the signals acquired by the at least one acquisition means in step e') and the synchronisation voltage acquired in step e').

13. Method executed by a computer (500) according to claim 11 or 12, wherein said method is further suitable for performing a successive acquisition of frequency spectra of signals of at least one of the sensors and displaying on the screen at the user's request the last frequency spectrum of the recorded signals, a spectrum averaged over the last n spectra and a spectrum of the maximum amplitudes of the signals recorded during successive acquisitions.
